# EUROPEAN PATENT APPLICATION

(11) **EP 4 766 140 A1**
(43) Date of publication of application: **24.06.2026**
(21) Application number: 25209535.1
(22) Date of filing: 17.10.2025
(51) Int. Cl.: H10W 70/60, H10W 70/63, H10W 70/685, H10W 70/692

(54) **THROUGH GLASS VIAS WITH MULTILAYERED ORGANIC/INORGANIC LINER FOR INTEGRATED CIRCUIT DEVICE PACKAGES**

(30) Priority: 18.12.2024 US 202418986590
(71) Applicant: Intel Corporation, Santa Clara, CA 95054 (US)
(72) Inventor: KAVIANI, Shayan, Phoenix, AZ 85044 (US); GRUJICIC, Darko, Chandler, AZ 85249 (US); TAVAKOLI, Elham, Phoenix, AZ 85048 (US); WALL, Marcel, Phoenix, AZ 85048 (US); SHANMUGAM, Rengarajan, Tempe, AZ 85283 (US); MOHAMMADIGHALENI, Madhi, Phoenix, AZ 85048 (US); KIM, Kihyun, Chandler, AZ 85286 (US); ZAMANI, Ehsan, Phoenix, AZ 85048 (US); PIETAMBARAM, Srinivas, Chandler, AZ 95249 (US)
(74) Representative: HGF

(57) **Abstract**

Integrated circuit (IC) die packages including a glass with conductive features embedded within the glass, such as through-glass vias (TGVs). The embedded features comprise metallization separated from the glass by an intervening multi-layered liner that includes both organic and inorganic material layers. In exemplary embodiments, the organic material has a low elastic (Young's) modulus to accommodate internal stress between the glass and the metallization. An inorganic material layer of the liner may be nitride, such as a metal nitride or silicon nitride, and in direct contact with the glass. The multi-layered liner stack may further comprise another inorganic material layer in contact with the metallization and encapsulating the organic material layer.

## Description

### BACKGROUND

In electronics manufacturing, IC packaging is a stage of semiconductor device fabrication in which an IC that has been monolithically fabricated on a chip (or die) is assembled into a "package" that can protect the IC chip from physical damage and communicatively connect the IC to other packaged IC chips and/or a scaled host component, such as a package substrate, or a printed circuit board. Multiple chips can be co-assembled, for example, into a multi-die package (MCP).

When an IC package undergoes multiple processing steps involving temperature and pressure loads, dissimilar materials within the package behave differently from one another, potentially resulting in deformation, known as "package warpage." Stiffer package substrate cores, for example of bulk glass, have been explored as low-warpage alternatives to organic resin-based cores. However, a glass substrate has a significantly lower CTE than conventional organic copper-clad cored or coreless substrates for IC die package architectures. When electrically conductive features, such as through-glass vias (TGVs), are formed within the glass substrate, the glass can be exposed to high stresses associated with the embedded conductive features. These high stresses can potentially result in mechanical failures and reduce IC device package yields.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 illustrates a flow diagram of methods for forming an IC device package structure including IC die coupled to a glass preform comprising through-glass vias (TGVs) lined with a multilayered stack including at least an inorganic material layer and an organic material layer, in accordance with some embodiments;
FIG. 2 and 3 illustrate cross-sectional views of an IC device package structure evolving to include TGV openings as one or more operations in the methods illustrated in FIG. 1 are performed, in accordance with some embodiments;
FIG. 4A, 4B and 4C illustrate cross-sectional views of a workpiece comprising an IC device package structure evolving to include a multi-layered material stack lining TGV openings as one or more operations in the methods illustrated in FIG. 1 are performed, in accordance with some embodiments;
FIG. 5A and 5B illustrated cross-sectional views of an IC device package structure evolving to include metallized TGVs as one or more operations in the methods illustrated in FIG. 1 are performed, in accordance with some embodiments;
FIG. 6, 7 and 8 illustrate cross-sectional views of an IC device package structure evolving to include multiple IC dies interconnected by an electrical routing structure built up on a side of a glass core that includes TGVs as one or more operations in the methods illustrated in FIG. 1 are performed, in accordance with some embodiments;
FIG. 9 illustrates a system including the IC device package structure illustrated in FIG. 8 attached to a host component with solder features, in accordance with some embodiments;
FIG. 10 illustrates a mobile computing platform and a data server machine employing device package structures comprising TGVs with a multilayered liner, in accordance with some embodiments; and
FIG. 11 is a functional block diagram of an electronic computing device, in accordance with some embodiments.

### DETAILED DESCRIPTION OF EXEMPLARY EMBODIMENTS

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

Integrated circuit (IC) device package structures including a glass core with embedded metallization, such as through-glass vias (TGVs), are described herein. An electrical routing structure comprising redistribution layer (RDL) metallization may be built-up on at least one side of the glass and electrically coupled to the metallization embedded within the glass. IC die(s) may be further assembled to the routing structure. In exemplary embodiments, the metallization embedded within the glass is lined with a multi-layered material stack including both an inorganic material layer and an organic material layer. The multi-layered liner may be absent from metal features of the routing structure(s).

A lower layer of the multi-layered liner may be of an inorganic material and may offer strong adhesion with a bulk glass surface for exemplary embodiments where the inorganic material is in direct contact with the glass. An upper layer of the multi-layered stack may be of an organic material and may have a low elastic (e.g., Young's) modulus that can accommodate (i.e., buffer) internal stress that develops between the glass and via metallization that is deposited into the TGVs (e.g., covering the intervening multi-layered liner). As described below, a multi-layered TGV liner may further comprise a capping layer that encapsulates an underlying organic material layer. The encapsulant may, for example, limit outgassing of an organic material and/or physically protect the organic material, which may be significantly softer than the encapsulant. The encapsulant may also promote adhesion between the liner and TGV metallization.

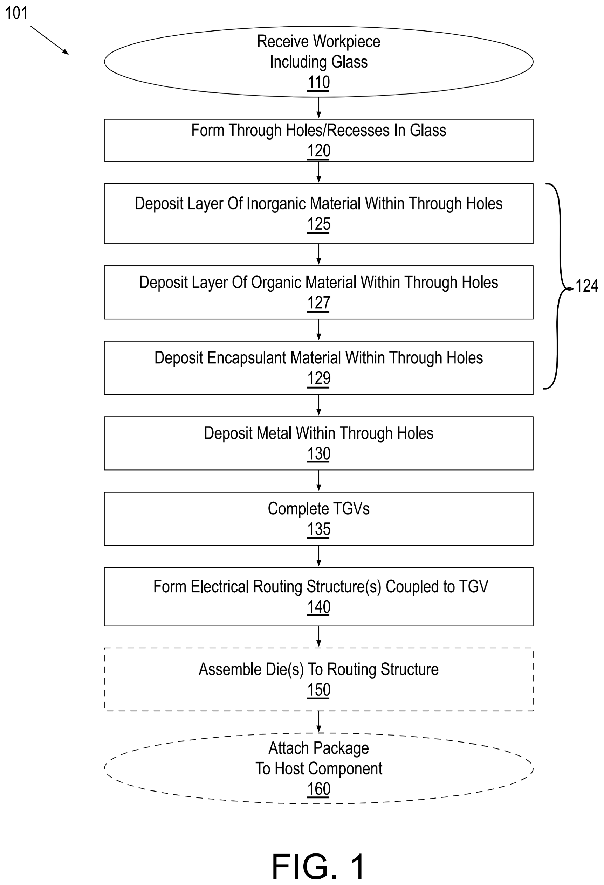

A variety of fabrication methods may be practiced to form IC device package structures having one or more of the features described herein. FIG. 1 illustrates a flow diagram of methods 101 for forming an IC device package structure including IC die coupled to a bulk glass layer comprising through-glass vias (TGVs) lined with a multi-layered material stack, in accordance with some embodiments. Methods 101 begin at input 110 where a workpiece including a thickness of glass is received. The workpiece may be prepared upstream of methods 101 and may be in a large panel format, a wafer format, or the like. In addition to the glass, the workpiece received at input 110 may comprise one or more materials upon which electrical routing structures may be formed.

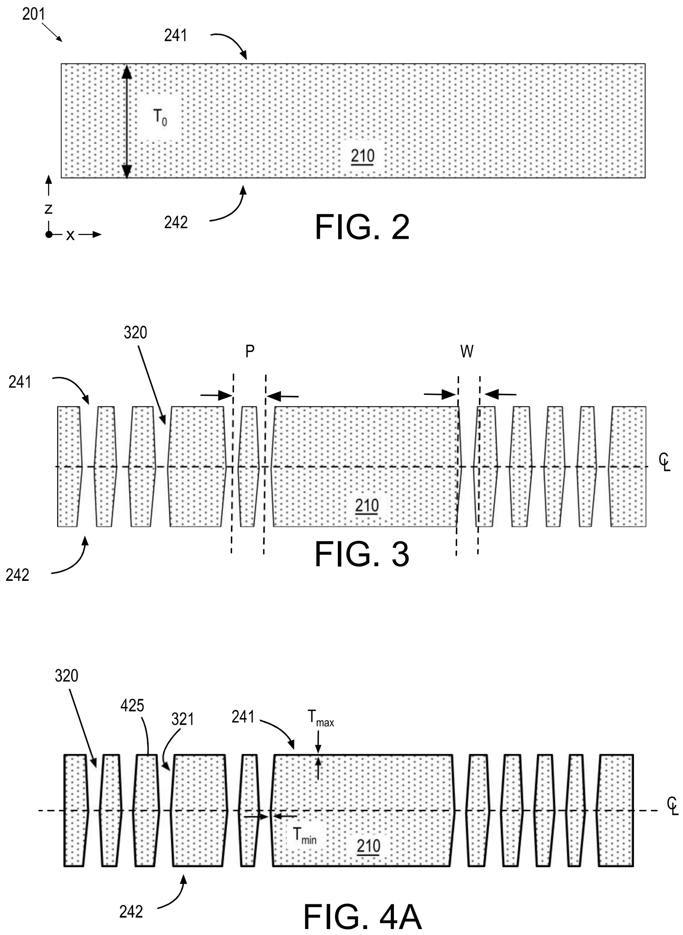

FIG. 2 is a cross-sectional view of an exemplary package substrate core 201 including glass 210. IC device package structures may be advantageously fabricated upon glass 210 as flatness and/or thickness control for a preform of glass may be superior to that of starting substrates based on organic materials (e.g., epoxy), and costs can be significantly lower than for monocrystalline materials (e.g., silicon). Glass 210 may also be stiffer than conventional core materials, such as a copper-clad laminate (CCL). Glass 210 is a solid bulk material layer that may have been previously formed into any shape in plan view (e.g., x-y plane) suitable for a packaging workpiece, such as rectangular. Glass 210 has a thickness T₀ that may vary with implementation, for example to limit warpage while remaining thin enough to permit the formation of through vias at a pitch as small as is enabled by the surface flatness of glass 210. In exemplary embodiments, thickness T₀ is advantageously 50 µm to 2000 µm. Organic adhesives and/or other organic material may be absent from glass 210. Glass 210 is advantageously a bulk material of substantially homogeneous composition in contrast to a composite material that may merely comprise glass fillers (particles) and/or glass fibers in a binder (e.g., epoxy). Although glass 210 is substantially amorphous in some embodiments, glass 210 may also have other morphology or microstructure, such as polycrystalline (e.g., nanocrystalline). Glass 210 may therefore be a rectangular prism volume distinguished from, for example, "prepreg," which typically includes glass fibers having a diameter in the range of 5-20 µm embedded in a resinous organic material, such as an epoxy.

Glass 210 may include a material comprising silicon and oxygen. Glass 210 is advantageously predominantly silicon and oxygen. In some embodiments, glass 210 comprises at least 23 percent silicon and at least 26 percent oxygen, by weight (i.e., wt. %). Glass 210 may further include one or more additives, such as, Aluminum, Boron, Magnesium, Calcium, Barium, Tin, Sodium, Potassium, Strontium, Phosphorus, Zirconium, Lithium, Titanium, or Zinc. In glass 210, the weight percentage of silicon is at least 0.5% (e.g., between about 0.5% and 50%), and may be between about 1% and 48%. For example, if glass 210 is specifically fused silica, the weight percentage of silicon may be about 47%. In some embodiments where glass 210 comprises at least 23 wt. % Si, glass 210 comprises at least 26 wt. % O. Additives within glass 210 may form suboxides (A₂O) monoxides (AO), binary oxides (AO₂), ternary oxides (ABO₃), and mixtures thereof. For example, glass 210 may comprise AlOₓ (e.g., Al₂O₃), BOₓ (e.g., B₂O₃), MgOₓ (e.g., MgO), CaOₓ (e.g., CaO), SrOₓ (e.g., SrO), BaOₓ (e.g., BaO), SnOₓ (e.g., SnO₂), NaOₓ (e.g., Na₂O), KOₓ (e.g., K₂O), POₓ(e.g., P₂O₃), ZrOₓ (e.g., ZrO₂), LiOₓ (e.g., Li₂O), TiOₓ (e.g., TiO₂), or ZnOₓ (e.g., ZnO₂). In some specific examples glass 210 further comprises at least 5 wt. % Al. Depending on chemical composition, glass 210 may therefore be referred to as silica, fused silica, aluminosilicate, soda-lime glass, soda-lime silica, borofloat glass, lead borate glass, borosilicate, or alumino-borosilicate, for example.

Although not depicted, one or more material layers may clad either or both of the front-side glass surface 241 or back-side glass surface 242 so that glass 210 is a bulk or core layer of a multi-layered substrate. Exemplary cladding materials include inorganic materials such as silicon nitride (SiNₓ) or silicon oxynitride (SiOₓN_{y}). In other embodiments, a silicon layer (polycrystalline or monocrystalline) may clad one or both sides of glass 210. Organic material layers, such as polymer dielectric materials, may also clad one or more sides of glass 210. Hence, while glass 210 is advantageously substantially free of organic materials (e.g., no adhesives, etc.), an IC die package workpiece may further include organic materials within a substrate that includes glass 210.

Returning to FIG. 1, methods 101 continue at block 120 where features (e.g., recesses and/or through holes) are formed in the glass. The features may be fabricated with any process known to be suitable for bulk glass. In some embodiments, block 120 comprises laser ablation, a glass etch process (laser-assisted, or otherwise), or any other technique known to be suitable for forming features (e.g., holes) through a thickness of the glass received at input 110 at a desired diameter and feature pitch.

FIG. 3 illustrates an exemplary embodiment indicative of a substantially symmetrical two-sided hole formation process resulting in through holes 320 that are substantially symmetric about a longitudinal z-axis (demarked in dashed line) but with a tapered (e.g., x dimension) lateral width W that is largest at each of glass surface 241 and glass surface 242. Through holes 320 have a smallest lateral width W proximal to one-half of thickness T₀ or a centerline plane of glass 210. The largest width W may vary with implementation. However, in some examples the largest width W is 100µm, or less, and advantageously 50µm, or less. Accordingly, the aspect ratio (T₀: largest width W) of through holes 320 may also vary with an exemplary aspect ratio range being 10:1-20:1.

In some embodiments where glass 210 has a thickness T₀ of at least 500µm, through holes 320 have a minimum lateral pitch P that is 200µm, or less, and advantageously 100µm, or less. Although the symmetrical taper illustrated in FIG. 3 is indicative of a two-sided through-hole formation process, single-sided asymmetrical though hole embodiments are also possible. While through holes are illustrated in FIG. 3, blind holes or recesses that do not pass entirely through thickness T₀ may also be fabricated into one or more of glass surface 241 or glass surface 242. Through holes 320 (or blind holes) may have any shape within a plan view (x-y) plane, such as substantially circular, rectangular, or any other polygon. The plan view shape of a through hole, or blind hole, may vary over thickness T₀.

Returning to FIG. 1, methods 101 continue with the implementation of a multi-process module 124 where a multi-layered liner is formed upon sidewalls of the features previously formed into the bulk glass. Multi-process module 124 comprises at least one inorganic material deposition 125 and at least one organic material deposition 127. Although either deposition 125 or 127 may proceed the other, in exemplary embodiments, inorganic material deposition 125 precedes organic material deposition 127. As further illustrated in FIG. 1, multi-process module 124 advantageously further comprises an encapsulant deposition 129, which is advantageously performed subsequent to organic material deposition 127. As described further below, through the practice of multi-process module 124, stress, for example stemming from a linear coefficient of thermal expansion (CTE) mismatch between the bulk glass and conductive material that is to be subsequently deposited into the openings formed in the glass, may be mitigated. As the magnitude of stress developed may vary with implementation, for example as a function of feature geometry and thermal loads placed on a package structure, implementations of multi-process module 124 may also vary. For example, inorganic and/or organic material compositions may vary and/or a thickness of an inorganic material layer and/or organic material layer may vary, and/or deposition techniques may vary as a function of the magnitude of stress developed for a particular IC package structure.

Notably, multi-process module 124 may be practiced as separate, discrete (ex-situ) process operations, or may be performed as multiple phases of an integrated (in-situ) process operation. In advantageous embodiments, multi-process module 124 is entirely "dry" processes, avoiding any "wet" deposition techniques. Dry deposition techniques are readily capable of forming thin films of material on sidewalls of features having a high aspect ratio (e.g., over 10:1), whereas wet deposition techniques may be suitable only for lower aspect ratios (e.g., 5:1-7:1).

Inorganic material deposition 127 comprises the deposition of at least one layer of inorganic material. In exemplary embodiments, inorganic material deposition 127 comprises a deposition process offering high film thickness conformality, such as chemical vapor deposition (CVD) or atomic layer deposition (ALD). In the example further illustrated in FIG. 4A, an inorganic material layer 425 has been deposited over glass surfaces 241, 242 as well as sidewalls 321 of openings 320. FIG. 4A illustrates a substantially conformal deposition where a maximum thickness Tₘₐₓ on surfaces 241, 242 that is within 10% of a minimum thickness Tₘᵢₙ on sidewall 321 proximal to the glass centerline at one-half of thickness T₀. For alternative embodiments where inorganic material layer 425 is deposited with a deposition process less conformal than CVD or ALD, such as a physical vapor deposition (PVD) process, inorganic material layer 425 may have a thickness Tₘᵢₙ proximal to the glass centerline that is at least 20% less than thickness Tₘₐₓ proximal to surfaces 241, 242. Although thicknesses Tₘₐₓ/Tₘᵢₙ of inorganic material layer 425 may vary with implementation, in exemplary embodiments minimum thickness Tₘᵢₙ is at least 10 nm and advantageously less than 1 µm, for example to limit the impact of a multi-layered liner on a through via's electrical resistance. For the illustrated embodiments that are highly conformal, inorganic material layer 425 may be thinner (e.g., both Tₘᵢₙ and Tₘₐₓ of 20-200 nm) than for non-conformal embodiments where Tₘₐₓ may be thicker (e.g., ~1 µm) to ensure a sufficient, non-zero Tₘᵢₙ (e.g., of 20-200 nm).

As shown in FIG. 4A, inorganic material layer 425 is in direct contact with glass 210, and for such embodiments inorganic material layer 425 advantageously comprises only trace levels of carbon below 1.0 wt %, if any. In further embodiments, inorganic material layer 425 comprises nitrogen. Functional groups comprising nitrogen (e.g., nitrides) can have particularly good adhesion to glass surfaces, reducing the risk of a liner delaminating from glass 210. Nitride functional groups may also promote good adhesion to a subsequently deposited organic material layer. In some embodiments, inorganic material layer 425 further comprises silicon, and may advantageously be a silicon nitride (SiNₓ) with one example being stoichiometric Si₃N₄. In some embodiments, inorganic material layer 425 comprises oxygen, either in combination with both silicon and nitrogen (e.g., SiOₓN_{y}) or in the absence of nitrogen (e.g., SiOₓ) where one example is stoichiometric SiO₂. Optionally, one or more metals may also be present in inorganic material layer 425. Exemplary metals include one or more of Ti (e.g., TiNₓ, TiOₓ, TiOₓN_{y}, TiSiₓ, TiSiₓO_{y}N_{z}), Ta (e.g., TaNₓ, TaOₓ, TaOₓN_{y}, TaSiₓ, TaSiₓO_{y}N_{z}), or W(e.g., WNₓ, WOₓ, WOₓN_{y}, WSiₓ, WSiₓO_{y}N_{z}). Other metals (e.g. com Al, Sn, Sc, In, or Au), and their nitrides, oxides, silicides, or silicates are also possible.

Returning to FIG. 1, methods 101 continue with organic material deposition 127. Organic material deposition 127 may comprise any deposition technique known to be suitable for the material composition. In some embodiments, one or more of spray-coating, dip-coating, or inkjet printing may be used to deposit one or more organic material layers, for example as a liquid, gel, or sol-gel. In other embodiments, a self-assembly techniques (e.g., driven by surface-charges) may be practiced to form an organic material layer. Following wet application, the organic material may be cured. Noting that organic material can be challenging to wet deposit in a manner that ensures side walls of high aspect ratio features are fully covered, in some advantageous embodiments, organic material deposition 127 is with a dry process, which may be a vapor deposition technique. In one example, an initiated chemical vapor deposition (iCVD) process deposits a polymeric material on sidewalls of openings, for example in direct contact with the inorganic material previously deposited. Generally, in iCVD techniques a monomer is deposited upon a workpiece surface and, an athermally activated initiator radical activates the monomer, initiating a polymerization reaction on the surface. Such techniques provide the opportunity for grafting a polymer directly on the inorganic material previously deposited. It is also possible to leave dangling bonds on the top surface of the organic material, providing bonding sites for a next material layer that could enhance adhesion with the organic material.

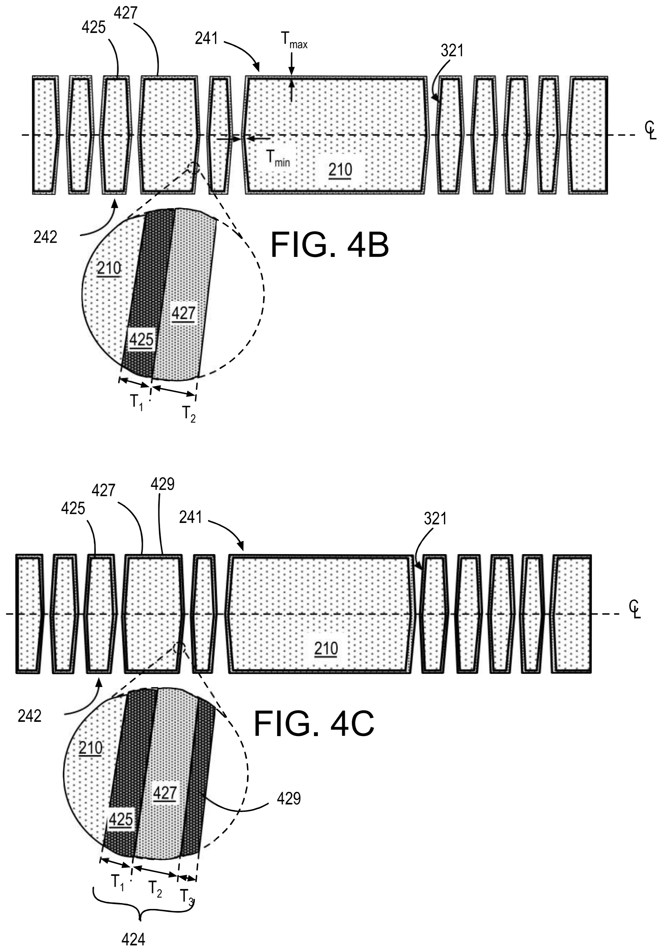

FIG. 4B illustrates an example where an organic material layer 427 has been deposited upon inorganic material layer 425. As shown in FIG. 4B, organic material layer 427 is in direct contact with inorganic material layer 425. Organic material layer 427 may also have a maximum thickness Tₘₐₓ on surfaces 241, 242 and a minimum thickness Tₘᵢₙ on sidewall 321. Depending on the variation between thicknesses Tₘₐₓ and Tₘᵢₙ, inorganic material layer 425 may be referred to as more or less conformal. In some embodiments, organic material layer 427 is less conformal than inorganic material layer 425, (i.e., Tₘₐₓ is greater than Tₘᵢₙ by a greater amount for organic material layer 427). In some examples where inorganic material layer 425 has a thickness variation of no more than 20%, organic material layer 427 has a thickness variation of more than 25%.

Although thicknesses Tₘₐₓ/Tₘᵢₙ of organic material layer 427 may vary with implementation, in exemplary embodiments minimum thickness Tₘᵢₙ is greater than that of inorganic material layer 425. As further illustrated in the expanded sectional view of sidewall 321, inorganic material layer 425 has a thickness T₁ along a direction perpendicular to the sidewall surface of glass 210. Along this same direction, organic material layer 427 has a thickness T₂ that is more than a few hundred nanometers greater than thickness T₁. In some advantageous embodiments, thickness T₂ is 0.5 µm to 5 µm. The greater thickness of organic material layer 427 is advantageous for accommodating stress, for example by straining over thickness T₂.

In exemplary embodiments, organic material layer 427 has a lower elastic modulus than inorganic material layer 425. While in some instances the modulus may be directly measured for thin films, references herein to elastic modulus are also applicable for bulk materials having substantially the same chemical composition and microstructure as the thin film. Hence, even if elastic modulus of inorganic material layer 425 and/or organic material layer 427 is not directly measurable, a material of substantially the same composition and microstructure may be formed to some greater thickness more amenable to modulus measurement. Absent evidence to the contrary, the modulus associated with such a bulk thickness is presumed to be closely matched with that of the thin film of substantially the same composition and microstructure.

In exemplary embodiments, organic material layer 427 is of a material having an elastic modulus less than 110 GPa. The inventors have found that materials with an elastic modulus significantly above this threshold (e.g., 120 GPa) may not accommodate sufficient internal stress and, when deposited within a hole extending through a low-CTE material (e.g., glass), a less compliant material(s) may suffer delamination. Some embodiments of organic material layer 427 may therefore have an elastic modulus advantageously below 100 GPa, and more advantageously below 90 GPa.

In further embodiments, organic material layer 427 is of a material have a relatively low (linear) coefficient of thermal expansion (e.g., < 20 ppm/K), which is compatible with the CTE of silica glass (e.g., 4-9 ppm/K). In some exemplary embodiments, organic material layer 427 may advantageously have a CTE in the range of 3-20 ppm/K, and more specifically in the range 5-12 ppm/K. While in some instances the CTE may be directly measured for organic material layer 427, references to CTE are also applicable for bulk materials having substantially the same chemical composition and microstructure as material layer 427. Hence, even if CTE of organic material layer 427 is not directly measurable, a material of substantially the same composition and microstructure may be formed to a greater thickness more amenable to CTE measurement. Absent evidence to the contrary, the CTE associated with such a bulk thickness is presumed to be closely matched with that of a thin film of substantially the same composition and microstructure.

The composition of organic material layer 427 may vary with deposition technique and may be determined, for example, through one or more of FTIR, Raman spectroscopy, AFM, AFM-IR, TEM, XPS, or X-EDS. Films deposited through iCVD, for example, may be identified by initiator content because polymer chains are initiated and terminated/capped by initiator radicals. Hence, monomer/initiator ratios determined through XPS or FTIR may be informative. Generally, organic material layer 427 may include at least one of a trifluoromethyl group, a carbonyl group, a sulfonyl group, or an ester group, which may all be detected by FTIR or XPS, for example.

In some embodiments, organic material layer 427 comprises Polytetrafluoroethylene (PTFE), Poly(Glycidyl Methacrylate) (PGMA), poly (1,3,5-trimethyl-1,3,5-trivinyl cyclotrisiloxane) (pV3D3), poly (1,3,5,7-tetravinyl-1,3,5, 7-tetramethylcyclotetrasiloxane) (pV4D4), or poly(1H, 1H, 2H,2H- perfluorodecyl acrylate (pPFDA). Such materials may be deposited by iCVD with an initiator such as tert-butyl peroxide (TBPO) for PGMA or Perfluoro butane sulfonyl fluoride (PBSF) for PTFE.

In some other embodiments, organic material layer 427 comprises a cationic polyelectrolyte, such as a π-conjugated oligomer or polymer. In some embodiments, organic material layer 427 is a one or more of poly (dialyldimethylammonium chloride) or polyethylenimine (PEI). Organic material layer 427 may also, or in the alternative, comprise an anionic polyelectrolyte, such as polystyrene sulfonate, or sulfonated polysulfone.

Returning to FIG. 1, methods 101 continue with encapsulant deposition 129, which may complete multi-process module 124. Encapsulant deposition 129 may cover the organic material previously deposited, for example reducing outgassing of polymeric material(s) and/or improving adhesion with a subsequently deposited metal. In some exemplary embodiments, encapsulant deposition 129 comprises an atomic layer deposition (ALD) or CVD process. In the example illustrated in FIG. 4C, an encapsulant material layer 429 has been deposited upon organic material layer 427. In this example, encapsulant material layer 429 is in direct contact with organic material layer 427. Encapsulant material layer 429 may have a maximum thickness Tₘₐₓ on surfaces 241, 242 and a minimum thickness Tₘᵢₙ on sidewall 321 with conformality of encapsulant material layer 429 being a function of variation between thicknesses Tₘₐₓ and Tₘᵢₙ. In some embodiments, encapsulant material layer 429 is more conformal than organic material layer 427, (i.e., Tₘₐₓ is greater than Tₘᵢₙ by a greater amount for organic material layer 427 than for encapsulant material layer 429). In some examples encapsulant material layer 429 has a thickness variation of less than 10% between thicknesses Tₘₐₓ and Tₘᵢₙ.

Although thicknesses of encapsulant material layer 429 may vary with implementation, in exemplary embodiments minimum thickness Tₘᵢₙ is less than that of organic material layer 427 and may also be less than that of inorganic material layer 425. As further illustrated in the expanded sectional view of sidewall 321 where inorganic material layer 425 has a thickness T₁ and organic material layer 427 has a thickness T₂, encapsulant material layer has a thickness T₃. In some advantageous embodiments, thickness T₃ is 1-20 nm. A multi-layered liner 424 may then comprise inorganic material layer 425 with a thickness T₁ of 20-500 nm, organic material layer 427 with a thickness T₂ of 0.5-5µm, and encapsulant material layer 429 with a thickness T₃ of 1-20 nm.

In exemplary embodiments, encapsulant material layer 429 has a higher elastic modulus than organic material layer 427. In exemplary embodiments, encapsulant material layer 429 is of a material having an elastic modulus exceeding 120 GPa. This higher elastic modulus may physically protect the underlying softer organic material layer 127 during subsequent processing.

The composition of encapsulant material layer 429 may vary with deposition technique and may again be determined through one or more of FTIR, Raman spectroscopy, AFM, AFM-IR, TEM, XPS, or X-EDS. In exemplary embodiments, encapsulant material layer 429 is an inorganic material (e.g., comprising no more than trace levels of carbon below 1.0 wt %). In some embodiments, encapsulant material layer 429 comprises nitrogen. Functional groups comprising nitrogen (e.g., nitrides) can have particularly good adhesion to organic materials, reducing the risk of encapsulant material layer 429 delaminating from organic material layer 427. In some embodiments, encapsulant material layer 429 comprises a metal, either in combination with nitrogen or in the absence of nitrogen. Exemplary metals and their nitrides include Ti (TiNₓ) Ta (TaNₓ), or W (WNₓ₎. In some embodiments, encapsulant material layer 429 also comprises oxygen, either in combination with one or more of a metal and nitrogen or in absence of one or more of a metal and nitrogen (e.g., TiOₓ, TiOₓN_{y}, TaOₓ, TaOₓN_{y}, WOₓ, WOₓN_{y}). Encapsulant material layer 429 may also comprise silicon, for example in combination with at least one of oxygen, nitrogen, or a metal(e.g., TiSiₓ, TiSiₓO_{y}N_{z}, TaSiₓ, TaSiₓO_{y}N_{z}, WSiₓ, WSiₓO_{y}N_{z}). Other metals (e.g. Al, Sn, Sc, In, or Au), and their nitrides, oxides, silicides, or silicates are also possible.

After forming the multi-layered liner, methods 101 continue with metal deposition 130 where lined openings or recesses in the glass are at least partially filled with electrically conductive metallization. In exemplary embodiments, metal deposition 130 comprises deposition of a seed metal followed by deposition of a fill metal. In some embodiments, a seed metal layer is deposited directly upon an encapsulant material of the underlying multi-layered liner. The metal present in the underlying encapsulant material layer may ensure good adhesion of seed metal. In some embodiments, the seed metal is deposited with an ALD process, which is advantageous where the aspect ratio of openings in the glass are over 10:1 following deposition of the liner. Alternatively, a seed metal may instead be deposited with a PVD process if greater seed layer non-conformality is tolerable. Following seed metal deposition, one or more fill metals (e.g., predominantly copper) may be deposited (e.g., electroplated) upon surfaces of the seed metal layer. Seed metal and/or fill metal may each have a significantly higher elastic modulus and/or CTE than at least one layer of the underlying liner. Fill metallization of predominantly Cu, for example, can be expected to have an elastic modulus of around 130 GPa and a CTE of 16-17 ppm/K.

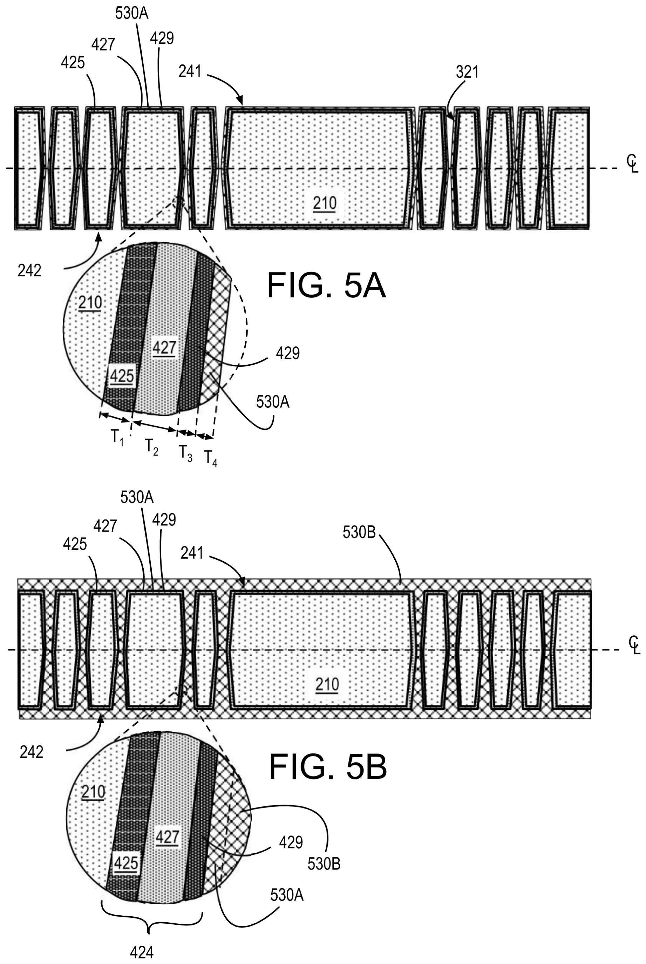

FIG. 5A illustrates an example where a seed metal layer 530A has been deposited directly upon encapsulant material layer 429. Seed metal layer 530A may be of any chemical composition known to be suitable as a seed layer for an electrodeposition process, for example having suitable electrical conductivity. For embodiments where encapsulant material layer 429 comprises a metal, seed metal layer 530A comprises a different metal than encapsulant material layer 429. Seed metal layer 530A may comprise other than Ti, Ta, or W, for example, and in some embodiments, seed metal layer 530A is predominantly Cu.

As shown the expanded view of FIG. 5A, seed metal layer 530A has a thickness T₄ along the direction of thicknesses T₁-T₃. Thickness T₄ may be, for example, within the same range as thickness T₃ (e.g., 1-20 nm) and may, in some embodiments, be at least 5 nm along sidewall 321 proximal to the centerline of glass thickness T₀. Conformality of seed metal material layer 530A may vary as a function of deposition technique with seed metal layer thickness T4 being lower along sidewall 321v proximal to the centerline of glass thickness T₀ for less conformal deposition process, such as PVD. FIG. 5B further illustrates plating of fill metal 530B upon seed metal layer 530A. As shown in the expanded view, even where seed metal layer 530A and fill metal 530B are of substantially the same composition (e.g., both predominantly Cu), an interface may be evident in TEM images revealing seed metal layer 530A to have different microstructure than fill metal 530B. For example, seed metal layer 530A may have smaller grain sizes (e.g., 5-20 nm grain diameters) than fill metal 530B (e.g., >25 nm grain diameters).

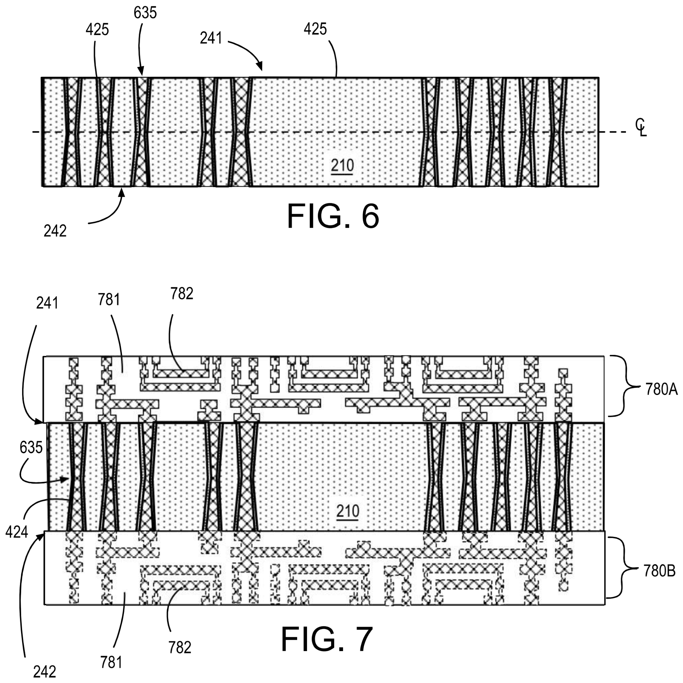

Returning to FIG. 1, methods 101 continue with TGV completion 135, for example where fill metallization, seed metallization and/or one or more layers of liner material is planarized to remove plating overburden from front and back sides of the glass. In the example illustrated in FIG. 6, fill metallization 530B and seed metal layer 530A has been removed from surfaces 241, 242, leaving conductive TGVs 635. Alternatively, the workpiece illustrated in FIG. 6 may also be obtained through chemical metal etch processes, with or without incorporating mechanical abrasion. In the illustrated example, encapsulant material layer 429 and organic material layer 427 has also been removed from surfaces 241, 242, exposing inorganic material layer 425. In other embodiments, inorganic material layer 425 may also be removed, exposing glass 210 at surface 241, 242.

Returning to FIG. 1, methods 101 continue at block 140 where an electrical routing structure is built-up upon one or more sides of the glass prior to its assembly with one or more IC die. The electrical routing structure may be electrically coupled to the TGVs and may, for example, comprise one or more levels of metallization features embedded within any suitable dielectric material. The electrical routing structure formed at block 140 may interconnect one or more IC die to each other and/or couple one or more of IC die to the TGVs. Accordingly, the metallization feature pitch of the routing structure is advantageously minimized for highest interconnect density. Before or after the formation of the routing structure(s), a glass substrate may be affixed to a handle or carrier having any suitable composition and of any suitable thickness, as embodiments herein are not limited in this respect.

In the example illustrated in FIG. 7, a routing structure 780A has been built-up over surface 241. Another routing structure 780B may be similarly built-up over surface 242. Routing structure 780B is illustrated in dashed line to emphasize double-sided build up is optional. Routing structure 780A(780B) comprises one or more levels of RDL metallization features 782 embedded within one or more layers of dielectric material 781. RDL metallization features 782 may comprise one or more metals, with one example being predominantly copper. At least some of RDL metallization features 782 are to electrically bridge together two or more IC dies, preferably with the finest metallization line:space feature pitch that can be directly patterned (e.g., <3 µm lines and spaces) for the flatness of glass 210. Routing structure 780A may comprises metallization features 782 that are to interconnect multiple IC dies to conductive TGVs 635. In some examples where the TGVs 635 comprise a multi-layered liner 424 in accordance with embodiments herein, at least the organic material layer 427 is absent from metallization features 782. Depending on the embodiment, dielectric material 781 may be any of a molding compound, a spin-on material, or dry film laminate material, for example. Dielectric material 781 may be introduced wet/uncured into a cast and then dried/cured. Alternatively, dielectric material 781 may be introduced as a semi-cured dry film that is fully cured following its application over glass 210. The composition of dielectric material 781 may vary with implementation. In some advantageous embodiments, dielectric material 781 is an organic dielectric, such as, an epoxy resin, phenolic-glass, or a resinous film such as the GX-series films commercially available from Ajinomoto Fine-Techno Co., Inc.(ABF). Dielectric material 781 may comprise epoxy resins (e.g., an acrylate of novolac such as epoxy phenol novolacs (EPN) or epoxy cresol novolacs (ECN)). In some specific examples, dielectric material 781 is a bisphenol-A epoxy resin, for example including epichlorohydrin. In other examples, dielectric material 781 includes aliphatic epoxy resin.

Returning to FIG. 1, methods 101 may continue at block 150 where at least one IC die is assembled to the workpiece and, more particularly, to the electrical routing structure. IC die assembled at block 150 may each comprise any electrical circuitry, with one example being logic circuitry comprising logic gates. IC die assembled at block 150 may also comprise any photonic circuitry suitable for the detection, emission, or processing (e.g., filtering, multiplexing and demultiplexing) of optical signals.

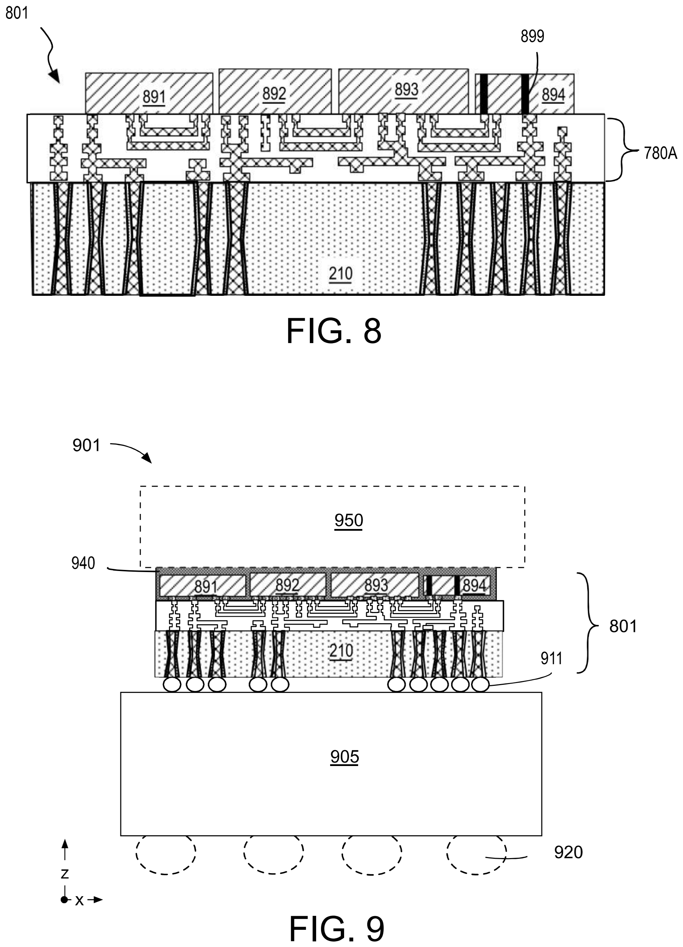

In the example illustrated in FIG. 8, IC die 891-894 are assembled to interconnect interfaces within a top metallization level of routing structure 780A as the first die of a co-packaged multi-die IC device package structure 801. IC die 891-894 may be directly bonded to routing structure 780A. Alternatively, IC die 891-894 may be electrically coupled through intervening electrical interconnects (not depicted), which may comprise solder of any suitable composition, for example. In the example illustrated, IC die 891-893 are each flip-chip attached with integrated circuitry within each die being proximal to front-side surface 241. IC die 894 however comprises through die vias 899 with integrated circuity being distal from package substrate surface 241.

Each of IC die 891-894 may be a fully functional ASIC, or may be a chiplet or tile that has more limited functionality supplementing the function of one or more other IC dies that are to be part of the same multi-die device. A chiplet or tile may, for example, be any of a wireless radio circuit, microprocessor core, electronic memory circuit, floating point gate array (FPGA), power management and/or power supply circuit, or include a MEMS device. In some examples, one or more of IC die 891-894 include one or more banks of active repeater circuitry to improve multi-die interconnects (e.g., network-on-chip architectures). In other examples, one or more of IC die 891-894 includes clock generator circuitry or temperature sensing circuitry. In other examples, one or more of IC die 891-894 include logic circuitry that, along with other IC die 891-894 implement multi-chiplet aggregated logic circuitry (e.g., mesh network-on-chip architectures). In some specific examples, at least one of IC die 891-894 includes microprocessor core circuitry, for example comprising one or more shift registers.

IC die 891-894 advantageously comprise field effect transistors (FETs) with a device pitch of 80nm, or less. The FETs may be of any architecture (e.g., planar, non-planar, single-gate, multi-gate, stacked nanosheet, etc.). In some embodiments, FET terminals have a feature pitch of less than 30 nm. Additionally, or in the alternative, IC die 891-894 may include active devices other than FETs. For example, IC die 891-894 may include electronic memory structures, such as magnetic tunnel junctions (MTJs), capacitors, or the like.

IC die 891-894 may comprise one or more IC die metallization levels embedded within an insulator. While the IC die metallization features may have any composition(s) of sufficient electrical conductivity, in exemplary embodiments, the IC die metallization features are predominantly copper (Cu). In other examples, the metallization features are predominantly other than Cu, such as, but not limited to predominantly Ru, or predominantly W. An uppermost one of the metallization features within IC die 891-894 may have a feature pitch ranging from 100 nm to several microns, for example.

Returning to FIG. 1, methods 101 complete where the assembled device package structure is further attached to a suitable host component at output 160. FIG. 9 illustrates an exemplary system 901 including one device package structure 801 attached to a host component 905 with interconnects 911, in accordance with some embodiments. In exemplary embodiments, interconnects 911 are solder (e.g., SAC) microbumps although other interconnect features are also possible. In some embodiments, host component 905 is predominantly silicon. Host component 905 may also comprise one or more alternative materials known to be suitable as interposers or package substrates (e.g., an epoxy preform, cored or coreless laminate board, etc.). Host component 905 may also include a printed circuit board (PCB). Host component 905 may include one or more metallized redistribution levels (not depicted) embedded within a dielectric material. Host component 905 may also include one or more IC die embedded therein.

Host component 905 may include interconnects 920 illustrated in dashed line. Each of interconnects 920 may comprise any solder (ball, bump, etc.) suitable for a given host board architecture (e.g., surface mount FR4, etc.). Also illustrated in dashed line, one or more heat spreaders and/or heat sinks 950 may be further coupled to device package structure 801, which may be advantageous, for example, where IC dies 891-894 comprise one or more CPU cores or other circuitry of similar power density. Any package dielectric 940, such as a mold material, may surround sidewalls of IC dies 891-894. Although not illustrated, package dielectric 940 may be background so that heat spreader/sink 950 may be in closer contact with IC dies 891-894,

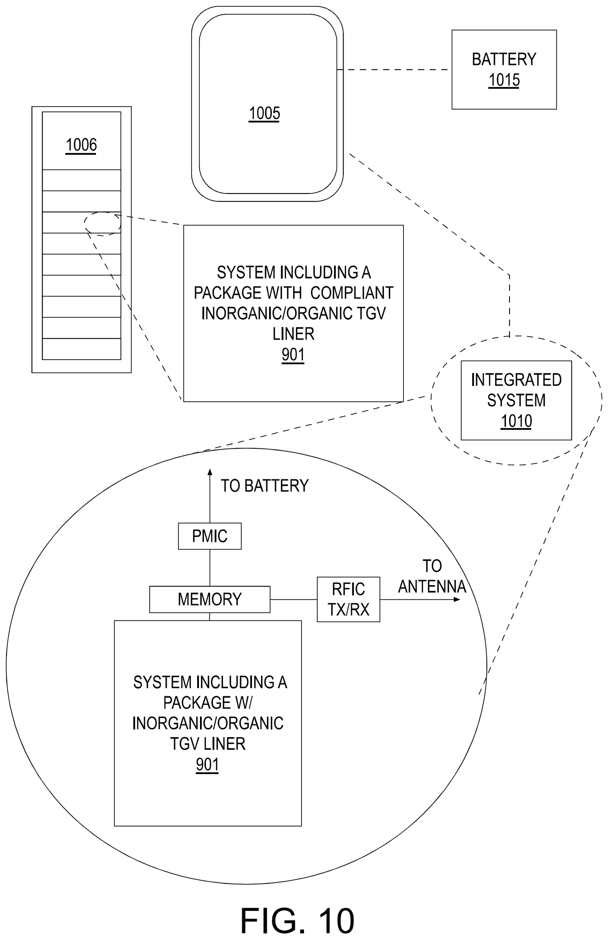

FIG. 10 illustrates a mobile computing platform 1005 and a data server machine 1006 employing an IC device package with TGVs including a multi-layered liner, for example as described elsewhere herein. Server machine 1006 may be any commercial server, for example including any number of high-performance computing platforms disposed within a rack and networked together for electronic data processing, which in the exemplary embodiment includes system 901, for example as described elsewhere herein. The mobile computing platform 1005 may be any portable device configured for each of electronic data display, electronic data processing, wireless electronic data transmission, or the like. For example, the mobile computing platform 1005 may be any of a tablet, a smart phone, laptop computer, etc., and may include a display screen (e.g., a capacitive, inductive, resistive, or optical touchscreen), an integrated system 1010, and a battery 1015.

As further illustrated in FIG. 10, system 901 may be coupled to one or more of a power management integrated circuit (PMIC) or RF (wireless) integrated circuit (RFIC) including a wideband RF (wireless) transmitter and/or receiver. A PMIC may perform battery power regulation, DC-to-DC conversion, etc., and so has an input coupled to battery 1015 and with an output providing a current supply to other functional modules. As further illustrated, in the exemplary embodiment, an RFIC has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, and beyond.

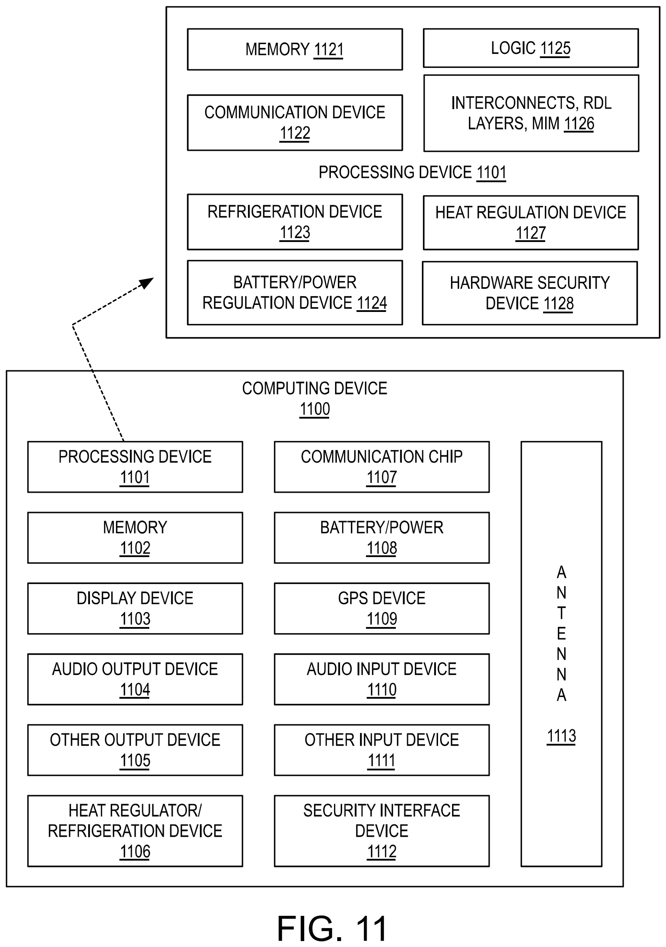

FIG. 11 is a block diagram of a cryogenically cooled computing device 1100 in accordance with some embodiments. For example, one or more components of computing device 1100 may include any of the devices or structures discussed elsewhere herein. A number of components are illustrated in FIG. 11 as included in computing device 1100, but any one or more of these components may be omitted or duplicated, as suitable for the application. In some embodiments, some or all of the components included in computing device 1100 may be attached to one or more printed circuit boards (e.g., a motherboard). In some embodiments, various ones of these components may be fabricated onto a single system-on-a-chip (SoC) die. Additionally, in various embodiments, computing device 1100 may not include one or more of the components illustrated in FIG. 11, but computing device 1100 may include interface circuitry for coupling to the one or more components. For example, computing device 1100 may not include a display device 1103, but may include display device interface circuitry (e.g., a connector and driver circuitry) to which display device 1103 may be coupled.

Computing device 1100 may include a processing device 1101 (e.g., one or more processing devices). As used herein, the term processing device or processor indicates a device that processes electronic data from registers and/or memory to transform that electronic data into other electronic data that may be stored in registers and/or memory. Processing device 1101 may include a memory 1121, a communication device 1122, a refrigeration/active cooling device 1123, a battery/power regulation device 1124, logic 1125, interconnects 1126, a heat regulation device 1127, and a hardware security device 1128.

Processing device 1101 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

Processing device 1101 may include a memory 1102, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 1121 includes memory that shares a die with processing device 1101. This memory may be used as cache memory and may include embedded dynamic random-access memory (eDRAM) or spin transfer torque magnetic random-access memory (STT-M RAM).

Computing device 1100 may include a heat regulation/refrigeration device 1106. Heat regulation/refrigeration device 1106 may maintain processing device 1101 (and/or other components of computing device 1100) at a predetermined low temperature during operation. This predetermined low temperature may be any temperature discussed elsewhere herein.

In some embodiments, computing device 1100 may include a communication chip 1107 (e.g., one or more communication chips). For example, the communication chip 1107 may be configured for managing wireless communications for the transfer of data to and from computing device 1100. The term "wireless" and its derivatives may be used to describe circuits, devices, systems, methods, techniques, communications channels, etc., that may communicate data through the use of modulated electromagnetic radiation through a nonsolid medium.

Communication chip 1107 may implement any wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). Communication chip 1107 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 1107 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 1107 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Computing device 1100 may include an antenna 1113 to facilitate wireless communications and/or to receive other wireless communications (such as AM or FM radio transmissions).

Computing device 1100 may include battery/power circuitry 1108. Battery/power circuitry 1108 may include one or more energy storage devices (e.g., batteries or capacitors) and/or circuitry for coupling components of computing device 1100 to an energy source separate from computing device 1100 (e.g., AC line power).

Computing device 1100 may include a display device 1103 (or corresponding interface circuitry, as discussed above). Display device 1103 may include any visual indicators, such as a heads-up display, a computer monitor, a projector, a touchscreen display, a liquid crystal display (LCD), a light-emitting diode display, or a flat panel display, for example.

Computing device 1100 may include an audio output device 1104 (or corresponding interface circuitry, as discussed above). Audio output device 1104 may include any device that generates an audible indicator, such as speakers, headsets, or earbuds, for example.

Computing device 1100 may include an audio input device 1110 (or corresponding interface circuitry, as discussed above). Audio input device 1110 may include any device that generates a signal representative of a sound, such as microphones, microphone arrays, or digital instruments (e.g., instruments having a musical instrument digital interface (MIDI) output).

Computing device 1100 may include a global positioning system (GPS) device 1109 (or corresponding interface circuitry, as discussed above). GPS device 1109 may be in communication with a satellite-based system and may receive a location of computing device 1100, as known in the art.

Computing device 1100 may include another output device 1105 (or corresponding interface circuitry, as discussed above). Examples include an audio codec, a video codec, a printer, a wired or wireless transmitter for providing information to other devices, or an additional storage device.

Computing device 1100 may include another input device 1111 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1100 may include a security interface device 1112. Security interface device 1112 may include any device that provides security measures for computing device 1100 such as intrusion detection, biometric validation, security encode or decode, managing access lists, malware detection, or spyware detection.

Computing device 1100, or a subset of its components, may have any appropriate form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the disclosure is not limited to the embodiments so described but can be practiced with modification and alteration without departing from the scope of the appended claims. For example, the above embodiments may include specific combinations of features as further provided below.

In first examples, an apparatus comprises a substrate comprising glass, a plurality of holes extending through the glass, a metallization within the holes, and a liner within the holes and between the metallization and the glass. The liner comprises an organic material between two inorganic material layers.

In second examples, for any of the first examples the organic material has an elastic modulus is less than 100 GPa.

In third examples, for any of the first through second examples the organic material has a thermal expansion coefficient (CTE) of less than 25 ppm/K.

In fourth examples, for any of the third examples the elastic modulus is less than 90 GPa and the CTE is at least 8 ppm/K.

In fifth examples, for any of the second through fourth examples the organic material has a layer thickness greater than a layer thickness of at least one of the inorganic material layers.

In sixth examples, for any of the first through fifth examples the organic material comprises Polytetrafluoroethylene (PTFE), Poly(Glycidyl Methacrylate) (PGMA), poly (1,3,5-trimethyl-1,3,5-trivinyl cyclotrisiloxane) (pV3D3), poly (1,3,5,7-tetravinyl-1,3,5, 7-tetramethylcyclotetrasiloxane) (pV4D4), or poly(1H, 1H, 2H,2H- perfluorodecyl acrylate (pPFDA), poly (dialyldimethylammonium chloride) or polyethylenimine (PEI), polystyrene sulfonate, or sulfonated polysulfone.

In seventh examples, for any of the first through sixth examples the organic material is in contact with a first inorganic material layer between the glass and the organic material, and wherein the organic material is in contact with a second inorganic material layer between the metallization and the organic material.

In eighth examples, for any of the seventh examples the first inorganic material layer comprises nitrogen at least one of a metal, silicon, or oxygen.

In ninth examples, for any of the seventh through eighth examples the first inorganic material layer is in contact with the glass.

In tenth examples, for any of the seventh through ninth examples the second inorganic material layer is in contact with the metallization.

In eleventh examples, for any of the seventh through tenth examples the second inorganic material layer comprises a metal.

In twelfth examples, for any of the eleventh examples the second inorganic material layer comprises the metal and nitrogen.

In thirteenth examples, for any of the eleventh through twelfth examples the first and second inorganic material layers each have a thickness below 200 nm.

In fourteenth examples, a system comprises a plurality of integrated circuit (IC) die electrically coupled to first metallization features on a first side of a substrate comprising glass, a plurality of holes extending through the glass, and a metallization within the holes. The metallization electrically couples the first metallization features to second metallization features on a second side of the glass. The substrate comprises a liner comprising at least one inorganic material layer in contact with at least one organic material layer, the liner within the holes and between the metallization and the glass.

In fifteenth examples, for any of the fourteenth examples the organic material is absent from the first metallization features.

In sixteenth examples, for any of the fourteenth through fifteenth examples the system further comprises an electrical routing structure on the first side of the glass, the routing structure comprising the first metallization features and an organic dielectric material, and wherein the plurality of holes extend from the routing structure to a second side of the glass, and wherein the routing structure electrically couples the metallization within the holes to at least one of the IC die.

In seventeenth examples the organic material has an elastic modulus less than 90 GPa and a coefficient of thermal expansion of at least 8 ppm/K. The organic material has a thickness of at least 500 nm.

In eighteenth examples, a method comprises receiving a workpiece comprising glass, forming through holes in the glass, and depositing a liner upon a sidewall of the holes and over a surface of the glass between the through holes. Depositing the liner comprises depositing a first inorganic material layer over the sidewall with a first vapor deposition process, depositing an organic material layer over the first inorganic material layer with a second vapor deposition process, and depositing a second inorganic material layer over the organic material layer with a third vapor deposition process. The method further comprise forming metallization within the holes and over the liner.

In nineteenth examples, for any of the eighteenth examples the second vapor deposition process comprises an initiated chemical vapor deposition (iCVD).

In twentieth examples, for any of the eighteenth through nineteenth examples the first and third vapor deposition processes comprise atomic layer deposition (ALD).

However, the above embodiments are not limited in this regard, and, in various implementations, the above embodiments may include the undertaking of only a subset of such features, undertaking a different order of such features, undertaking a different combination of such features, and/or undertaking additional features than those features explicitly listed. The scope of the disclosure should therefore be determined with reference to the appended claims, along with the full scope of equivalents to which such claims are entitled.

## Claims

1. An apparatus, comprising:
a microelectronic device package substrate comprising glass;
a plurality of holes extending through the glass;
a metallization within the holes; and
a liner within the holes and between the metallization and the glass, wherein the liner comprises an organic material between two inorganic material layers.

2. The apparatus of claim 1, wherein the organic material has an elastic modulus less than 100 GPa.

3. The apparatus of claim 1 or claim 2, wherein the organic material has a thermal expansion coefficient (CTE) of less than 25 ppm/K.

4. The apparatus of claim 3, wherein the elastic modulus is less than 90 GPa and the CTE is at least 8 ppm/K.

5. The apparatus of any one of claims 1-4, wherein the organic material has a layer thickness greater than a layer thickness of at least one of the inorganic material layers.

6. The apparatus of claim any one of claims 1-5, wherein the organic material comprises Polytetrafluoroethylene (PTFE), Poly(Glycidyl Methacrylate) (PGMA), poly (1,3,5-trimethyl-1,3,5-trivinyl cyclotrisiloxane) (pV3D3), poly (1,3,5,7-tetravinyl-1,3,5, 7-tetramethylcyclotetrasiloxane) (pV4D4), or poly(1H, 1H, 2H,2H- perfluorodecyl acrylate (pPFDA), poly (dialyldimethylammonium chloride) or polyethylenimine (PEI), polystyrene sulfonate, or sulfonated polysulfone.

7. The apparatus of any one of claims 1-6, wherein the organic material is in contact with a first inorganic material layer between the glass and the organic material, and wherein the organic material is in contact with a second inorganic material layer between the metallization and the organic material.

8. The apparatus of claim 7, wherein:
the first inorganic material layer comprises nitrogen at least one of a metal, silicon, or oxygen.
the second inorganic material layer comprises a metal; and
the first and second inorganic material layers each have a thickness below 200 nm.

9. The apparatus of any one of claims 1-8, further comprising:
a plurality of integrated circuit (IC) die electrically coupled to first metallization features on a first side of the microelectronic device package substrate.

10. The apparatus of claim 9, further comprising an electrical routing structure on the first side of the glass, the routing structure comprising the first metallization features and an organic dielectric material, and wherein the plurality of holes extend from the routing structure to a second side of the glass, and wherein the routing structure electrically couples the metallization within the holes to at least one of the plurality of IC die.

11. The apparatus of claim 10, wherein the organic material has an elastic modulus less than 90 GPa and a coefficient of thermal expansion of at least 8 ppm/K, and wherein the organic material has a thickness of at least 500 nm.

12. A method comprising:
receiving a workpiece comprising glass;
forming through holes in the glass;
depositing a liner upon a sidewall of the holes and over a surface of the glass between the through holes, wherein depositing the liner comprises:
depositing a first inorganic material layer over the sidewall with a first vapor deposition process;
depositing an organic material layer over the first inorganic material layer with a second vapor deposition process; and
depositing a second inorganic material layer over the organic material layer with a third vapor deposition process; and
forming metallization within the through holes and over the liner.

13. The method of claim 12, wherein the second vapor deposition process comprises an initiated chemical vapor deposition (iCVD).

14. The method of claim 12 or claim 13, wherein the first and third vapor deposition processes comprise atomic layer deposition (ALD).

15. The method of any one of claims 12-14, further comprising forming an electrical routing structure on a first side of the glass, the routing structure comprising interconnect metallization features within an organic dielectric material, and wherein the through holes extend from the routing structure to a second side of the glass.
